Europäisches Patentamt

European Patent Office

Office européen des brevets

(11) Publication number: **0 458 596 A1**

# (12) EUROPEAN PATENT APPLICATION

(21) Application number: 91304596.9

(22) Date of filing: 21.05.91

(51) Int. Cl.⁵: **H01B 3/12, H01G 4/12, C04B 35/46**

(30) Priority: 21.05.90 JP 130482/90

(43) Date of publication of application:
27.11.91 Bulletin 91/48

(84) Designated Contracting States:
DE FR GB

(71) Applicant: SHARP KABUSHIKI KAISHA
22-22 Nagaike-cho Abeno-ku
Osaka 545 (JP)

(72) Inventor: Ehara, Shaw
1-10-6, Sakyo
Nara-shi, Nara-ken (JP)

(74) Representative: West, Alan Harry et al
R.G.C. Jenkins & Co. 26 Caxton Street
London SW1H 0RJ (GB)

(54) Dielectric thin film and its preparation method.

(57) A dielectric thin film made of a composition comprising mixed crystals of 95 to 60 mol% of strontinum titanate (SrTiO₃), 1 to 20 mol% of barium titanate (BaTiO₃) and 1 to 20 mol% of calcium titanate (CaTiO₃), to which 0.1 to 5.0 mol% of oxides of one or more kinds of metals selected from the group consisting of copper, nickel, cobalt, iron, manganese and chrome is added, provided that the total mol% of the mixed crystals and oxides is 100 mol% in the composition, which has a good quality to exhibit stable electrical characteristies.

The invention relates to a dielectric thin film which has a good quality to exhibit stable electrical characteristics, particularly, a high dielectric constant to be applicable to various electronic devices, and a method for the preparation of the dielectric thin film.

DRAms (Dynamic Random Access Memories) which are typical high density LSIs (Large Scale Integrated Circuits) at present have a less amount of area for capacitor electrodes in memory cells as the number of memory cells increases. For keeping a capacity of the capacitor with the less amount of device area at a value larger than a predetermined value, the dielectric film is made thinner or a capacitor in a trench or stacked type has been employed hitherto. However, these methods have already reached the limit in respect of techniques and cost of production due to complexity of the structure of devices and problems created in production.

The conventional dielectric film for DRAM capacitors is made of $SiO_2$ which can provide a very thin film and is superior in insulating property and dielectric strength, but the $SiO_2$ film has low dielectric constant as $\xi \simeq 4.5 \sim 4.6$. When it is realized to use a material of high dielectric constant for preparation of a dielectric film for DRAM capacitors, the above-mentioned problem of capacitors may be substantially solved. But, the studies hitherto made in this regard have not achieved a flat and high insulating thin film which is made of material of high dielectric constant and suitable for formation of capacitors. For example, US Patent No. 4,981,714 (Sharp Kabushiki Kaisha) discloses a dielectric thin film of high dielectric constant made of $LiNb_{1-x}Ta_xO_3$ (O<X<1) by use of plasma CVD process. Also, it is known that an insulating film of high dielectric constant is made of $Ta_2O_3$ by optical CVD process or plasma CVD process [Y. Tarui et al., Extended Abstracts of the 19th SSDM, p219 (1987); K. Kanayama et al., Extended Abstracts of the 36th spring meeting, Vol.12, p703 (1989)].

The present invention has been designed to solve the problems of the conventional dielectric thin film for capacitors.

The present invention provides a dielectric thin film which is flat and has electrical characteristics as high dielectric constant and high insulating property, and an effective preparation method for the thin film.

According to the present invention, it provides a dielectric thin film made of a composition comprising mixed crystals of 95 to 60 mol% of strontinum titanate ($SrTiO_2$), 1 to 20 mol% of barium titanate ($BaTiO_3$) and 1 to 20 mol% of calcium titanate ($CaTiO_3$), to which 0.1 to 5.0 mol% of oxides of one or more kinds of metals selected from the group consisting of copper, nickel, cobalt, iron, manganese and chrome is added, the total mol% of the mixed crystals and oxides being 100 mol% in the composition, and a preparation method for the dielectric thin film.

Fig. 1 is a schematic diagram showing an example of the apparatus to the preparation of the dielectric thin film of the present invention

Fig. 2 is a diagram showing a mechanically taken section of the dielectric thin film of the example.

The thin film of the present invention exhibits high dielectric constant and high insulating property and can be formed with a combination of the following materials.

(1) Perovskite oxide dielectric

Perovskite oxides are materials known as of high dielectric constant. $BaTiO_3$ among the known materials exhibits highest dielectric constant, but it is ferroelectric at normal temperature to have hysteresis and deformation of crystals, so that the material is hard to provide a stable thin film due to its own properties.

The dielectric thin film of the present invention is made of $SrTiO_3$ of a stable structure as the main component, to which $BaTiO_3$ is mixed for increasing dielectric constant and reducing its change to temperatures and $CaTiO_3$ is also mixed for reducing oxygen deficiency and improving film's breakdown voltage high. In the composition to form the film, a preferable dielectric thin film can be obtained when $SrTiO_3$ is 95 to 60 mol%, preferably 80 to 70 mol%, $BaTiO_3$ is 1 to 20 mol%, preferably 1 to 10 mol%, and $CaTiO_3$ is 1 to 20 mol%, preferably 10 to 20 mol%. The mixed crystals may be improved in insulating property by adding the following additives.

(2) Additives

Dielectric constant is generally high in ionic bonding property, so that oxygen deficiencies or impurities serve or act as a donor or an acceptor in formation of dielectric. Energy level of electrons bound by the deficiencies or impurities is revealed that specific values taken from the base of energy band become smaller in reverse proportion to the second power of dielectric constant according to continuum approximation in quantum mechanics, and orbital radiuses defining spreading of the electrons become larger in proportion to the dielectric constant. Hence, materials of high dielectric constant are likely to generate carriers due to the deficiencies and the generated carriers have a high mobility, so that the resultant dielectric is sensitive in electrical characteristic to its own structure. For example, dielectric made of $BaTiO_3$ and the like is known to have properties as a semiconductor. That is, any oxide forming a thin film by vacuum deposition process and the like is likely to have oxygen deficiencies to cause $O_2$ to escape, having the same reaction as that of two positive electric charge electrons in the ionic crystal similarly with the above-mentioned donor, so that the dielectric is caused to serve as a semiconductor.

2

As seen from the above, it will be appreciated that for giving high insulating property to a dielectric thin film, it is required to use a film formation technique less causing oxygen deficiencies and provide a composition enabling electrical neutralization of such oxygen deficiencies.

In detail, we first confirmed that when $CaTiO_3$ is mixed to mixed crystals including $SrTiO_3$ as the main component it reduces oxygen deficiencies of the mixed crystal because of high activity of Ca ion to oxygen.

Then was found that the above-mentioned oxygen deficiencies can be mitigated by adding to the mixed crystals Cu, Ni, Co, Fe, Mn or Cr metal having electrons more than the half of the capacity of 3d orbits. The above mentioned ion which is substituted for Ti ion in the crystal acts to counterpoise the electrostatic positive potential caused by oxygen deficiency, that is the positive valence is smaller than that of Ti to neutralize a positive charge generated by oxygen deficiencies in the mixed crystal.

Cu and Mn among the above-mentioned metals to be admixed were confirmed to have an especially remarkable effect on the mixed crystals. The metals in the form of oxide were added to the mixed crystals in loadings of 0.1 to 5.0 mol% in the composition, preferably 1 to 3 mol%.

Further, it was found that a stiff and flat thin film of dielectrics having the above-mentioned composition can be especially effectively formed by ionizing a constituent material in vacuum or in the range of low gas pressure by a known thin film formation process according to ion technology and depositing the ionized material by use of kinetic energy obtained by applying voltage to the ionized material.

The composition for formation of the thin film of high dielectric constant of the present invention is provided by mixing materials of high dielectric constant with that for stabilizing the film structure and adding to the mixture an atom for increasing insulating properties.

The above-mentioned composition for formation of the dielectric can be processed by itself to be a stiff and flat thin film by a known film formation process according to ion technology.

The thin film after deposition may be applied with heating for 0.5 to 1 hour at high temperature, for example, 800 to 1000°C in the atmosphere of oxygen gas and/or in that of inactive gas (such as $N_2$, Ar and the like). Either heating process does well, but it is preferable to conduct both of them to further improve dielectric strength of the resultant thin film.

Next, an example of preparation of the thin film of dielectric having the composition according to the present invention will be detailed with referring to the attached drawings.

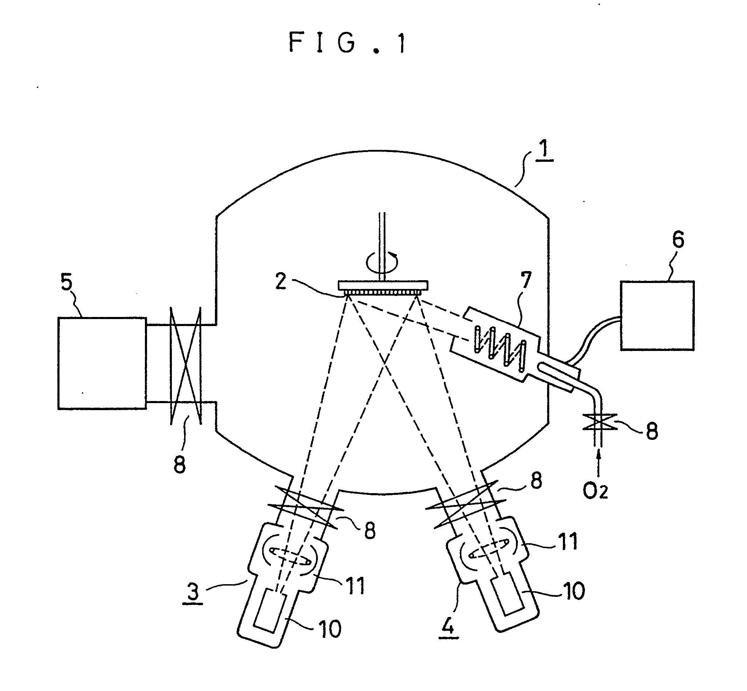

The example of the present invention used ICB(ion cluster beam) process which is suitable for accurately fabricating a thin film of oxide. Fig. 1 is a sectional view showing a profile of the ICB thin film fabricating apparatus, wherein a vacuum reactor chamber 1 is 450mm in inner diameter and 600mm high and connected through a valve 8 with a cryopump (Name of Product: ULVAC, CRYO, U-10P) of a main exhaust system 5 whose pumping speed is 2250 1/sec for $N_2$ gas, with also mounting a rotary pump for supporting the cryopump and two additional sorption pumps (Name of Product: ULVAC, PSM-10) arranged in parallel to each other to conduct rough pumping so as to finally obtain high vacuum of $5 \times 10^{-10}$ Torr. The reactor chamber 1 is provided with two cluster ion sources 3, 4 and an activated oxygen gas source 7. The cluster ion sources 3 and 4 each includes a graphitic crucible 10 of a capacity of about 5cc, a heater for the crucible 10 and an ionizing part 11, so that material placed in the crucible 10 is heated by the heater to jet in the form of cluster beam to the ionizing part 11 and be ionized thereat by application of electron beam from an annular thermion source of the ionizing part 11. The ionized cluster beam is given kinetic energy by voltage applied to the valve 8 of the ion cluster beam sources 3 and 4 to be emitted toward a substrate 2 for an aimed device.

In this example, material which is an alloy formed by adding 2 at% of copper to titanium metal was placed in one beam source 3, and in the other beam source 4 was placed material which is an alloy made of 75 at% of strontium, 20 at% of calcium and 5 at% of barium. The radical oxygen source 7 is provided to feed an active oxygen gas onto the surface of the substrate 2 to bind the ions from the beam sources 3 and 4 with oxygen. The radical oxygen source 7 applied RF power of 13.56 MHz from RF power source 6 to the introduced oxygen ($O_2$) to generate plasma and send the oxygen gas which contains reactive oxygen, such as Ozon $O_3$, which activated 10% or more on the substrate surface through a gas outlet about 1 to 2cm near the substrate 2 to have $10^{-2}$ Torr of partial pressure of oxygen.

The two beam sources 3 and 4 each were provided with a film thickness meter (not shown) for measuring evaporation to monitor and adjust that evaporation of each beam sources 3 and 4 is equal to desired ratio of ingredient and a deposition speed on the substrate is 100A/min.

The substrate 2 used a wafer which is n-type Si (100) and of specific resistance of 100Ωcm and was mounted on a wafer holder in an autorotation type. Temperature of the substrate during deposition was kept at 500°C. The substrate 2 may employ several types of substrates (for example, a glass substrate) other than Si. Further, the cluster beam from the beam sources 3 and 4 is adapted to accelerate ion cluster through application of 500V of voltage and use kinetic energy of ions struck onto the substrate 2 as a spreading energy on the substrate surface so as to improve crystallizability of the film 1.

Table 1 shows the requirements for preparation of the thin film dielectric as above.

| TABLE 1 | REQUIREMENT FOR FILM FORMATION |
|---|---|
| Items | Content |
| Evaporating material in Beam Source | Crucible 3:  Ti 98at% + Cu 2at% <br> Crucible 4:  Sr 75at% + Ca 20at% + Ba 5at% |
| Accelerating voltage for cluster | 500 V |
| Vacuum | ab. $10^5$ Torr (excluding the peripheral portion of the substrate) |
| Partial pressure of oxygen | ab. $10^{-2}$ Torr (on the substrate surface) Oxygen is activated by application of RF power of 100W. |
| Deposition speed | ab. 10 nm/min |

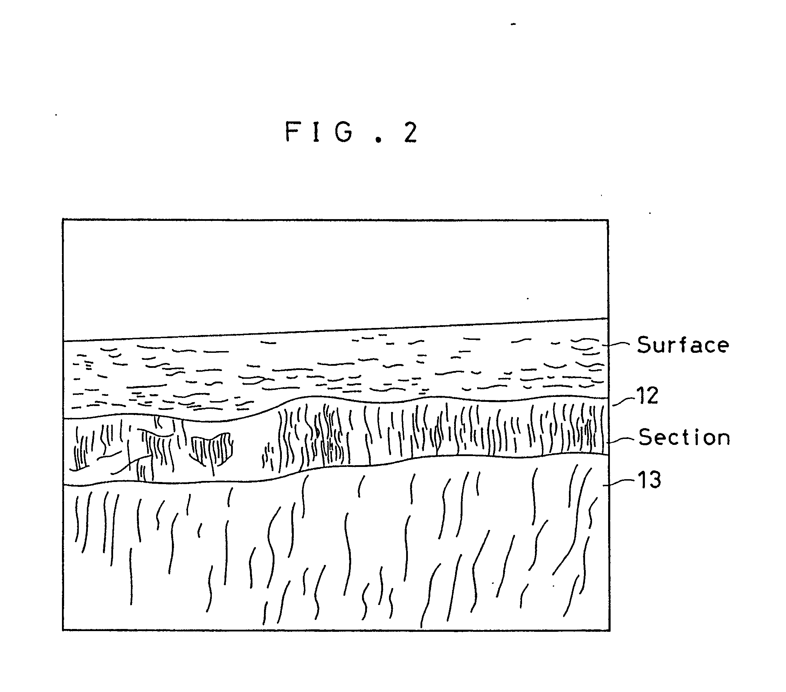

Four 10mm x 10mm square Si substrates 13 were placed on the above-mentined substrate holder to deposit the thin film dielectrics 12. One of the thin film dielectrics were divided together with a substrate 13 mechanically and the section was observed by SEM as shown in Fig. 2. As appreciated in the drawing, the thin film 12 was crystallized and grown to be less convexed and concaved and preferably flat on the surface. Thickness of the film 12 was ab. 600nm.

Electrical characteristics of the resultant dielectric thin film 1 were measured through electrodes of In-Ga alloy set on both sides of the film by use of LCR meter 4262A of Huret & Packard Inc. The result of measurement is shown in Table 2. Measurement signal level was 1V and temperature was 23°C.

TABLE 2   ELECTRICAL CHARACTERISTICS OF THIN FILM DIELECTRIC

| Items | Measured Values | | |
|---|---|---|---|
| Frequencies | 120 Hz | 1 KHz | 10 KHz |
| Capacities (C) | 150 $\mu$F | 120 $\mu$F | 120 $\mu$F |
| Dielectric constant($\varepsilon$) | 100 | 87 | 87 |
| Resistance (600nmt) | $\leq$ 10 M$\Omega$ | $\geq$ 10 M$\Omega$ | $\leq$ 10 M$\Omega$ |
| Specific re-sistance | >1.6x10$^{11}\Omega$cm | >1.6x10$^{11}\Omega$cm | >1.6x10$^{11}\Omega$cm |

From the measured values, the dielectric thin film 1 is seen to have high dielectric constant and high insulating property and also be stiff, flat and smooth while error in Table 1 is regarded to be about 20% at maximum in measurement of thickness and shape of the film.

When the resultant dielectric thin film is used for DRAM capacitors, the capacitors have a capacity of about 1200 fF a area of 1 $\mu$m x 1 $\mu$m and the film has a sufficiently high insulation resistance, thereby providing an aimed dielectric thin film which may be effectively applicable to high density LSI.

Time constant of the capacitor using the dielectric thin film of the present example is estimated to be about 100 msec that is sufficiently long in comparison with the existing refresh cycle when the dielectric thin film is applied to DRAM.

Furthermore, when the dielectric thin film of the present example five times larger in thickness (= 3$\mu$m) for increasing dielectric strength is applied to the DRAM capacitors, the capacitor still has an enough capacity of 240 fF to satisfy the requirement concerned.

In the present example, temperature of the substrate upon deposition of the dielectric thin film was set relatively low to 500°C for preventing deterioration or lowering of a possibly provided semiconductor device or its function in Si substrate 2. Possible factors to the success of the present example providing the stiff thin film dielectric of a preferable crystallizability at the low substrate temperature 500°C are the use of ICB process of ion technology and the application of activated oxygen as well as the special composition for the materials.

The dielectric thin film has been detailed with referring to the example but it should not be limited thereto. The composition of the dielectric thin film of the present invention and the resultant thin film of the excellent properties fabricated by the preparing method of the present invention are broadly applicable to the existing electronic technology. Also, the preparing method of the present invention may be modified for special usage.

According to the composition for dielectric thin film of the present invention and the preparing method thereof, a thin film dielectric which has high dielectric constant, a stiff crystalline structure and a flat and smooth surface can be deposited on a substrate of a relatively lower temperature.

Hence, properties of electronic devices essentially comprising a thin film dielectric are largerly improved.

## Claims

1. A dielectric thin film made of a composition comprising mixed crystals of 95 to 60 mol% of strontinum titanate (SrTiO$_2$), 1 to 20 mol% of barium titanate (BaTiO$_3$) and 1 to 20 mol% of calcium titanate (CaTiO$_3$), to which 0.1 to 5.0 mol% of oxides of one or more kinds of metals selected from the group consisting of copper, nickel, cobalt, iron, manganese and chrome is added, provided that the total mol% of the mixed crystals and oxides is 100 mol% in the composition.

2. A thin film dielectric set forth in claim 1, wherein the composition comprises 80 to 70 mol% of strontium titanate, 1 to 10 mol% of barium titanate, 10 to 20 mol% of calcium titanate and 1 to 3 mol% of copper oxide.

3. A method for the preparation of a dielectric thin film comprising the steps: to ionize atoms, which form the composition set forth in claim 1, in vacuum or in the range of low gas pressure and to accelerate the ionized atoms by use of voltage and deposit them on a substrate to form the dielectric thin film.

4. A method of claim 3, wherein the resultant dielectric thin film is further subjected to high temperature heating in the atmosphere of oxygen gas and/or in that of inactive gas.

# F I G . 1

FIG. 2

13

Section

12

Surface

EP 0 458 596 A1

## EUROPEAN SEARCH REPORT

European Patent Office

Application Number

EP 91304596.9

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | CHEMICAL ABSTRACTS, vol. 87, no. 6, August 8, 1977, Columbus, Ohio, USA YAMADA, KUNIHARU "Dielectric ceramics for temperature compensation capacitors." page 550, abstract-no. 47 194c & JP-A2-52-41 896 (SOWA SEIKOSHA) | 1 | H 01 B 3/12 H 01 G 4/12 C 04 B 35/46 |
| A | GB - A - 2 096 128 (N.A. PHILIPS) * Claims * | 1 | |

TECHNICAL FIELDS SEARCHED (Int. Cl.5)

H 01 B 3/00
H 01 G 4/00
C 04 B 35/00

The present search report has been drawn up for all claims

| Place of search | Date of completion of the search | Examiner |
|---|---|---|
| VIENNA | 13-08-1991 | KUTZELNIGG |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

9